(19) Europäisches Patentamt
European Patent Office
Office européen des brevets

(11) Veröffentlichungsnummer: **0 573 805 A1**

(12) **EUROPÄISCHE PATENTANMELDUNG**

(21) Anmeldenummer: **93107786.1**

(51) Int. Cl.5: **G03F 7/029**, G03F 7/027

(22) Anmeldetag: **13.05.93**

(30) Priorität: **27.05.92 DE 4217495**

(43) Veröffentlichungstag der Anmeldung:
**15.12.93 Patentblatt 93/50**

(84) Benannte Vertragsstaaten:
**DE FR GB NL**

(71) Anmelder: **HOECHST AKTIENGESELLSCHAFT**

**D-65926 Frankfurt(DE)**

(72) Erfinder: **Albrecht, Christine, Dr.**
**Haneckstrasse 8**
**W-6238 Hofheim/Ts.(DE)**
Erfinder: **Frass, Werner, Dr.**
**Erbsenacker 37**
**W-6200 Wiesbaden(DE)**
Erfinder: **Zertani, Rudolf, Dr.**
**Peterbergstr. 12**
**D - 55234 Bechtolsheim(DE)**

(54) **Photopolymerisierbares Gemisch und daraus hergestelltes Aufzeichnungsmaterial.**

(57) Es wird ein photopolymerisierbares Gemisch beschrieben, das 5 - 25 % eines polymeren Bindemittels, 60 - 90 % einer radikalisch polymerisierbaren Verbindung und als Photoinitiatoren insgesamt 3 - 20 % eines photoreduzierbaren Farbstoffs, einer durch Strahlung spaltbaren Trihalogenmethylverbindung und einer Metallocenverbindung enthält. Das Gemisch dient zur Herstellung von Photoresists oder Druckplatten und zeichnet sich durch eine besonders hohe Lichtempfindlichkeit aus.

EP 0 573 805 A1

Die Erfindung betrifft ein photopolymerisierbares Gemisch, das ein polymeres Bindemittel, eine polymerisierbare Verbindung, insbesondere einen Acryl- oder Alkacrylsäureester, sowie eine Photoinitiatorkombination enthält.

Photopolymerisierbare Gemische der angegebenen Gattung sind bekannt.

In der EP-A 287 817 werden photopolymerisierbare Gemische beschrieben, die (Meth)acrylsäureester mit Urethangruppen, tertiären Aminogruppen und ggf. Harnstoffgruppen im Molekül, polymere Bindemittel und, als Photoinitiatoren, eine Kombination aus einem photoreduzierbaren Farbstoff, einer strahlungsempfindlichen Trihalogenmethylverbindung und einer Acridin-, Phenazin- oder Chinoxalinverbindung enthalten.

In der EP-A 364 735 werden photopolymerisierbare Gemische beschrieben, die gleiche oder ähnliche Bindemittel und polymerisierbare Verbindungen sowie eine Photoinitiatorkombination aus photoreduzierbarem Farbstoff, einer durch Strahlung spaltbaren Trihalogenmethylverbindung und einer Metallocenverbindung enthalten. Diese Gemische zeichnen sich durch eine besonders hohe Lichtempfindlichkeit, vor allem im sichtbaren Spektralbereich, aus. Diese Eigenschaft macht sie insbesondere zur Herstellung von Druckplatten geeignet, die sich mit sichtbarem Laserlicht, z. B. mit einem Argon-Ionen-Laser, bebildern lassen. Diese bekannten Gemische enthalten im allgemeinen 20 bis 90, bevorzugt 40 bis 80 Gew.-% Bindemittel. Für die vorstehend genannte Anwendung sowie auch für die Bebilderung durch Projektionsbelichtung besteht immer noch ein Bedürfnis nach Erhöhung der Lichtempfindlichkeit.

Aufgabe der Erfindung war es, photopolymerisierbare Gemische vorzuschlagen, die sich zur Herstellung von Druckplatten der in der EP-A 364 735 beschriebenen hohen Leistungsfähigkeit eignen und deren Lichtempfindlichkeit im nahen Ultraviolett- und insbesondere im sichtbaren Spektralbereich gegenüber den dort beschriebenen Gemischen noch weiter gesteigert ist.

Erfindungsgemäß wird ein photopolymerisierbares Gemisch vorgeschlagen, das als wesentliche Bestandteile

a) ein polymeres Bindemittel,

b) eine radikalisch polymerisierbare Verbindung mit mindestens einer polymerisierbaren Gruppe und als Photoinitiatoren

c) einen photoreduzierbaren Farbstoff,

d) eine durch Strahlung spaltbare Trihalogenmethylverbindung und

e) eine Metallocenverbindung

enthält, dadurch gekennzeichnet, daß das Bindemittel (a) in einer Menge von 5-25 %, die polymerisierbare Verbindung (b) in einer Menge von 60-90 % und die Photoinitiatoren (c), (d) und (e) in einer Menge von insgesamt 3-20 %, bezogen auf das Gewicht der nichtflüchtigen Bestandteile, vorliegen.

Die als Initiatorbestandteil einsetzbaren Metallocene sind als Photoinitiatoren aus der EP-A 364 735 bekannt. Bevorzugt werden Metallocene von Elementen der IV. Nebengruppe des Periodensystems, insbesondere Verbindungen des Titans und Zirkons. Von den zahlreichen bekannten Metallocenen, insbesondere Titanocenen, werden Verbindungen der allgemeinen Formel I

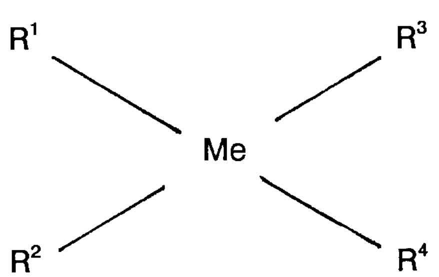

(I)

bevorzugt. In dieser Formel bedeuten

Me ein vierbindiges Metallatom, insbesondere Ti oder Zr,

$R^1$ und $R^2$ gleiche oder verschiedene Cyclopentadienylreste, die substituiert sein können, und

$R^3$ und $R^4$ gleiche oder verschiedene Phenylreste, die auch substituiert sein können.

Die Cyclopentadienylgruppen können insbesondere durch Alkylreste mit 1 bis 4 Kohlenstoffatomen, Chloratome, Phenyl- oder Cyclohexylreste substituiert oder durch Alkylengruppen miteinander verknüpft sein.

$R^3$ und $R^4$ sind bevorzugt Phenylgruppen, die in o-Stellung zur Bindung mindestens ein Fluoratom enthalten und im übrigen durch Halogenatome, wie F, Cl oder Br, Alkyl- oder Alkoxygruppen mit 1 bis 4 Kohlenstoffatomen oder eine ggf. veretherte oder veresterte Polyoxyalkylengruppe substituiert sein können.

Die Polyoxyalkylengruppe hat im allgemeinen 1 bis 6 Oxyalkyleneinheiten und steht bevorzugt in 4-Stellung des Phenylrests und kann durch einen Alkyl- oder Acylrest mit 1 bis 18 Kohlenstoffatomen verethert bzw. verestert sein; sie ist insbesondere eine Polyoxyethylengruppe. Phenylreste, die mit 4 oder 5 Fluoratomen substituiert sind, werden besonders bevorzugt. Der Mengenanteil an Metallocenverbindung liegt im allgemeinen zwischen 1,5 und 10, vorzugsweise bei 2 bis 6 Gew.-%, bezogen auf die nichtflüchtigen Anteile des Gemischs.

Das erfindungsgemäße Gemisch enthält als weiteren Photoinitiatorbestandteil einen photoreduzierbaren Farbstoff. Geeignete Farbstoffe sind insbesondere Xanthen-, Benzoxanthen-, Benzothioxanthen-, Thiazin-, Pyronin, Porphyrin- oder Acridinfarbstoffe.

Geeignete Xanthen- und Thiazinfarbstoffe sind z. B. in der EP-A 287 817 beschrieben.

Geeignete Benzoxanthen- und Benzothioxanthenfarbstoffe sind in der EP-A 321 828 beschrieben.

Als Porphyrinfarbstoff ist z. B. Hämatoporphyrin und als Acridinfarbstoff z. B. Acriflaviniumchlorid-Hydrochlorid geeignet. Beispiele für Xanthenfarbstoffe sind Eosin B (C.I. Nr. 45 400), Eosin J (C.I. Nr. 45 380), Eosin alkohollöslich (C.I. Nr. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Thiazinfarbstoffe sind Thionin (C.I. Nr. 52 000), Azur A (C.I. Nr. 52 005) und Azur C (C.I. Nr. 52 002).

Beispiele für Pyroninfarbstoffe sind Pyronin B (C.I. Nr. 45 010) und Pyronin GY (C.I. Nr. 45 005). Die Menge des photoreduzierbaren Farbstoffs liegt im allgemeinen zwischen 1 und 10, vorzugsweise zwischen 3 und 8 Gew.-%, bezogen auf die nichtflüchtigen Anteile des Gemischs.

Zur Steigerung der Lichtempfindlichkeit enthalten die erfindungsgemäßen Gemische ferner Verbindungen mit photolytisch spaltbaren Trihalogenmethylgruppen, die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt zwei Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich der Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B das Phenyltribrommethylsulfon, sind geeignet.

Diese Halogenverbindungen werden im allgemeinen in einer Menge von 0,05 bis 4, vorzugsweise von 0,25 bis 1 Gew.-%, bezogen auf die nichtflüchtigen Bestandteile des Gemischs, eingesetzt.

Die Gesamtmenge an diesen drei notwendigen Initiatorkomponenten beträgt 3-20, vorzugsweise 6-12 Gew.-%. Der Anteil an Titanocenverbindung liegt dabei bevorzugt zwischen 30 und 55, der an Trihalogenmethylverbindung zwischen 3 und 15 und der an photoreduzierbarem Farbstoff zwischen 40 und 67 Gew.-%, bezogen auf die Gesamtmenge an Photoinitiatoren (c), (d) und (e).

Die erfindungsgemäßen Gemische enthalten ggf. als weiteren Initiatorbestandteil eine Acridin-, Phenazin- oder Chinoxalinverbindung. Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Geeignete Vertreter dieser Verbindungsklasse sind in den genannten DE-C beschrieben. Die Menge dieser Komponente im Gemisch liegt im Bereich von 0 bis 5 Gew.-%, vorzugsweise zwischen 0,05 und 3 Gew.-%.

Wenn eine weitere Empfindlichkeitssteigerung des Gemischs im sichtbaren Spektralbereich erwünscht ist, kann diese durch Zusatz einer Verbindung vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4'-disubstituierte Dibenzalacetone, z. B. 4-Diethylamino-4'-methoxy-dibenzalaceton, oder Cumarinderivate wie 3-Acetyl-7-diethylamino-, 3-Benzimidazolyl-7-diethylamino- oder Carbonyl-bis-(7-diethylamino-cumarin). Die Menge dieser Verbindung liegt im Bereich von 0 bis 5, vorzugsweise von 0,05 bis 2 Gew.-%, bezogen auf die nichtflüchtigen Bestandteile des Gemischs.

Für die Zwecke der Erfindung geeignete polymerisierbare Verbindungen sind bekannt und z. B. in den US-A 2 760 863 und 3 060 023 beschrieben.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan,

Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Besonders bevorzugt werden polymerisierbare Verbindungen, die mindestens eine photooxydierbare und gegebenenfalls mindestens eine Urethangruppe im Molekül enthalten. Als photooxydierbare Gruppen kommen insbesondere Aminogruppen, Harnstoffgruppen, Thiogruppen, die auch Bestandteile heterocyclischer Ringe sein können, und Enolgruppen in Betracht. Beispiele für derartige Gruppen sind Triethanolamino-, Triphenylamino-, Thioharnstoff-, Imidazol-, Oxazol-, Thiazol-, Acetylacetonyl-, N-Phenylglycin- und Ascorbinsäuregruppen. Polymerisierbare Verbindungen mit primären, sekundären und insbesondere tertiären Aminogruppen werden bevorzugt.

Beispiele für Verbindungen mit photooxydierbaren Gruppen sind in den EP-A 287 818, 355 387 und 364 735 beschrieben. Von den dort beschriebenen Verbindungen werden solche bevorzugt, die außer einer tertiären Aminogruppe noch eine Harnstoffgruppe und/oder eine Urethangruppe enthalten. Als Harnstoffgruppen sollen Gruppen der Formel

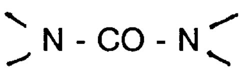

angesehen werden, bei denen die Valenzen am Stickstoff mit ggf. substituierten Kohlenwasserstoffresten abgesättigt sind.

Der Mengenanteil der photopolymerisierbaren Schicht an polymerisierbaren Verbindungen beträgt im allgemeinen etwa 60 bis 90, bevorzugt 70 bis 85 Gew.-%, bezogen auf die nichtflüchtigen Bestandteile.

Beispiele für verwendbare Bindemittel sind Poly(meth)acrylsäurealkylester, bei denen die Alkylgruppe z. B. Methyl, Ethyl, n-Butyl, i-Butyl, n-Hexyl oder 2-Ethyl-hexyl ist, Copolymere der genannten (Meth)-acrylsäurealkylester mit mindestens einem Monomeren, wie Acrylnitril, Vinylchlorid, Vinylidenchlorid, Styrol oder Butadien; Polyvinylacetat, Vinylacetat-Copolymere, Polyurethane, Methylcellulose, Ethylcellulose, Polvvinylformal und Polvvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydrorylgruppenhaltiger Polymerer mit Dicarbonsäureanhydriden sowie deren Mischungen.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:
Copolymerisate der (Meth)acrylsäure mit Alkyl(meth)acrylaten, (Meth)acrylsäurenitril oder dergleichen, Vinylacetat-Copolymerisate, Copolymerisate der Crotonsäure mit Vinylacetat, Alkyl(meth)acrylaten, (Meth)-acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäurenahydrids, Veresterungsprodukte von Hydroxylgruppen enthaltenden Polymeren mit Anhydriden von Di- oder Polycarbonsäuren, z.B. von Copolymerisaten der Hydroxyalkyl(meth)acrylate mit Alkyl(meth)acrylaten, (Meth)-acrylsäurenitril oder dergleichen, von Polyurethanen, sofern sie eine ausreichende Anzahl freier OH-Gruppen aufweisen, von Epoxyharzen, Polyestern, teilverseiften Vinylacetat-Copolymeren, Polyvinylacetalen mit freien OH-Gruppen, Copolymerisaten der Hydroxystyrole mit Alkyl(meth)acrylaten oder dergleichen; sowie Phenol-Formaldehyd-Harze, z. B. Novolake.

Die Menge des Bindemittels in der lichtempfindlichen Schicht beträgt im allgemeinen 5 bis 25, vorzugsweise 10 bis 19 Gew.-%.

Die photopolymerisierbaren Schichten können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile

sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung und Laserstrahlung. Die Lichtempfindlichkeit reicht von etwa 300 nm bis 700 nm und umspannt damit einen sehr breiten Bereich.

Durch die Kombination von photoreduzierbaren Farbstoffen mit photolytisch spaltbaren Halogenverbindungen und Metallocenen wird ein synergistisch wirkendes Initiatorsystem erhalten, das besonders im langwelligen Spektralbereich bei oder oberhalb 455 nm sehr aktiv ist. Besonders hohe Lichtempfindlichkeiten werden in Kombination mit polymerisierbaren Verbindungen erhalten, die photooxydierbare Gruppen enthalten. Gegenüber den bekannten Gemischen der vorstehenden Zusammensetzung zeichnen sich die erfindungsgemäßen Gemische, die wesentlich geringere Mengen an Bindemitteln und andere Mengenverhältnisse an Initiatoren enthalten, durch eine weiter gesteigerte Lichtempfindlichkeit aus.

Als Anwendungsmöglichkeiten für das erfindungsgemäße Material seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Als Schichtträger für das erfindungsgemäße Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Durch die breite spektrale Empfindlichkeit des erfindungsgemäßen Aufzeichnungsmaterials können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen progammierten Strich- und/oder Raster-Bewegung gesteuert werden.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Polyvinylalkohol, Polyphosphate, Zucker usw.. Solche Deckschichten haben im allgemeinen eine Dicke von 0,1 bis 10, vorzugsweise 1 bis 5 $\mu$m.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben. Die Entwicklerlösungen können einen kleinen Anteil, vorzugsweise weniger als 5 Gew.-%, an mit Wasser mischbaren organischen Lösemitteln enthalten. Sie können ferner Netzmittel, Farbstoffe, Salze und andere Zusätze enthalten.

Bei der Entwicklung wird die gesamte Deckschicht zusammen mit den unbelichteten Bereichen der photopolymerisierbaren Schicht entfernt.

Im folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

<u>Beispiele 1-7</u> <u>(Vergleichsbeispiele)</u>

Lösungen von

| | | |
|---|---|---|
| 2,87 | Gt | eines polymeren Bindemittels, |
| 6,76 | " | des Umsetzungsprodukts von 1 mol Triethanolamin mit 3 mol Isocyanatoethylmethacrylat, |
| 0,18 | " | Eosin alkohollöslich (C.I. 45 386) |
| 0,14 | " | 2,4-Bis-trichlormethyl-6-(4-styryl-phenyl)-s-triazin und |
| 0,05 | " | Dicyclopentadienyl-bis-pentafluorphenyl-titan in |
| 85 | " | Propylenglykolmonomethylether und |
| 46 | " | Butanon |

wurden auf elektrolytisch aufgerauhte und anodisch oxydierte Aluminiumplatten mit einer Oxidschicht von 3 $g/m^2$ aufgebracht, die zuvor mit einer wäßrigen Lösung von Polvvinylphosphonsäure vorbehandelt worden waren. Die Schichten wurden 2 Minuten bei 100 °C im Umluftrockenschrank getrocknet und hatten dann ein Schichtgewicht von 2,1 $g/m^2$. Anschließend wurde eine 8%ige wäßrige Lösung von Polvvinylalkohol (12 % Restacetylgruppen, K-Wert 4) in solcher Dicke aufgebracht, daß nach dem Trocknen (2 Minuten bei 100 °C) ein Schichtgewicht von 2,4 $g/m^2$ erhalten wurde.

Die erhaltenen Druckplatten wurden jeweils 20 s mit einer 60 W-Glühlampe im Abstand von 80 cm unter einem 13-stufigen Standard-Stufenkeil mit Dichtestufen von 0,15 belichtet. Nach dem Belichten wurden die Platten eine Minute bei 100 °C nacherwärmt und dann mit einem Entwickler der folgenden Zusammensetzung entwickelt:

| | | |
|---|---|---|
| 1 | Gt | Trinatriumcitrat x 2 $H_2O$, |
| 2 | " | 1-Amino-propanol-2, |
| 1,4 | " | Benzylalkohol, |
| 1,5 | " | Natriumcumolsulfonat (40%ige Lösung) |
| 0,04 | " | Natriummetasilikat x 5 $H_2O$ |
| 0,02 | " | Fettalkoholpolyglykolether (nichtionogenes Netzmittel) |
| 94,04 | " | Wasser |

In einem weiteren Versuch wurden die lichtempfindlichen Platten ohne bildmäßige Belichtung mit dem Entwickler behandelt. Die folgenden Bindemittel wurden eingesetzt:

| | |
|---|---|
| Beispiel 1 | Terpolymeres aus Styrol, n-Hexylmethacrylat und Methacrylsäure (10:60:30; Säurezahl 190) |
| Beispiel 2 | Copolymeres aus Styrol und Maleinsäurehalbester (Säurezahl 185; (®Scripset 540) |
| Beispiel 3 | Copolymeres aus 95 % Vinylacetat und 5 % Crotonsäure |
| Beispiel 4 | Copolymeres aus 65 % Vinylacetat und 35 % Dibutylmaleinat |
| Beispiel 5 | Copolymeres aus Acrylsäure, Styrol und α-Methylstyrol, Säurezahl 245; $M_w$ 7000 |

Beispiel 6 Reaktionsprodukt eines Polyvinylbutyrals (71 % Vinylbutyral-, 2 % Vinylacetat-, 27 % Vinylalkoholeinheiten, $M_w$ = 70000-80000) mit Maleinsäureanhydrid; Säurezahl 30

Beispiel 7 Methylmethacrylat/Methacrylsäure-Copolymeres, Säurezahl 117

In der Tabelle 1 sind die Ergebnisse zusammengestellt. Die zweite Spalte gibt die Zahl der vollständig gehärteten Keilstufen an. Die Vergleiche zeigen, daß bei dem angegebenen Bindemittelgehalt keine der Schichten derart befriedigend entwikkelt werden konnte, daß die belichteten Schichtbereiche unangegriffen blieben und die unbelichteten vollständig entfernt wurden.

Tabelle 1

| | mit Belichtung | | ohne Belichtung |
|---|---|---|---|
| | Keilstufen | Bemerkungen | |
| 1 | 4 | - | teilweise entschichtet |
| 2 | - | nicht entwickelt | teilweise entschichtet |
| 3 | 1 | - | vollständig entschichtet |
| 4 | - | ganz entschichtet | vollständig entschichtet |
| 5 | - | nicht entwickelt | teilweise entschichtet |
| 6 | - | nicht entwickelt | nicht entschichtet |
| 7 | - | nicht entwickelt | teilweise entschichtet |

Beispiele 8-10 (Vergleichsbeispiele)

Wie in Beispiel 1 beschrieben. wurden Druckplatten hergestellt, wobei das Monomere durch die in Tabelle 2 angegebenen Monomeren in gleicher Menge ersetzt wurde. Die Verarbeitung erfolgte wie in Beispiel 1 beschrieben; Tabelle 2 zeigt die Anzahl der vollständig gedeckten Keilstufen.

Tabelle 2

| Beispiel | Monomeres | Keilstufen |
|---|---|---|
| 1 | wie dort angegeben | 4 |
| 8 | Umsetzungsprodukt aus 2 mol Isocyanatoethylmethacrylat und 1 mol 2-Hydroryethyl-piperidin | 4 |
| 9 | Umsetzungsprodukt aus 3 mol Isocyanatoethylmethacrylat und 1 mol Diethanolamin | 3 |
| 10 | Umsetzungsprodukt aus 2 mol Hexamethylendiisocyanat, 2 mol Hydroxyethylmethacrylat und 1 mol 2-Hydroxyethyl-piperidin | 4 |

Beispiel 11 (Vergleichsbeispiel)

Eine Druckplatte wurde hergestellt wie in Beispiel 1 beschrieben. Dabei wurde die folgende Beschichtungslösung eingesetzt:

| | | |
|---|---|---|
| 2,87 | Gt | des Terpolymeren aus Beispiel 1 |
| 6,64 | " | des Umsetzungsprodukts aus 2 mol Hexamethylendiisocyanat, 2 mol 2-Hydroxy-ethylmethacrylat, und 1 mol 2-(2-Hydroxy-ethyl)-piperidin, |

| | | |
|---|---|---|
| 0,18 | Gt | Eosin alkohollöslich, |
| 0,14 | " | des in Beispiel 1 angegebenen Triazins, |
| 0,05 | " | des in Beispiel 1 angegebenen Titanocens und |
| 0,12 | " | Renolblau (C.I. 20 505) in |
| 85 | " | Propylenglykolmonomethylether und |
| 46 | " | Butanon. |

Nach Belichten und Entwickeln wie in Beispiel 1 wurden 4-5 vollgedeckte Keilstufen erhalten.

Beispiel 12 (Vergleichsbeispiel)

Es wurde wie in Beispiel 11 gearbeitet, jedoch wurde als Monomeres die in Beispiel 1 angegebene Verbindung in gleicher Menge wie in Beispiel 11 eingesetzt. Es wurden 4 vollgedeckte Keilstufen erhalten.

Beispiel 13 (Vergleichsbeispiel)

Es wurde wie in Beispiel 11 gearbeitet, jedoch wurde als Monomeres das Umsetzungsprodukt aus 2 mol Isocyanatoethylmethacrylat und 1 mol 2-(2-Hydroxyethyl)piperidin in gleicher Menge wie in Beispiel 11 eingesetzt. Es wurden 4 vollgedeckte Keilstufen erhalten.

Beispiel 14 (Vergleichsbeispiel)

Es wurde wie in Beispiel 11 gearbeitet, jedoch wurde als Monomeres das Umsetzungsprodukt aus 3 mol Isocyanatoethylmethacrylat und 1 mol Diethanolamin in gleicher Menge wie in Beispiel 11 eingesetzt. Es wurden 3 vollgedeckte Keilstufen erhalten.

Beispiel 15 (Vergleichsbeispiel)

Druckplatten wurden wie in Beispiel 11 hergestellt, wobei die Mengen der Bestandteile jeweils wie folgt geändert wurden:

a)

| | |
|---|---|
| 6,36 Gt | Monomeres (- 0,28) |
| 0,46 " | Eosin (+ 0,28) |

b)

| | |
|---|---|
| 6,74 Gt | Monomeres (+ 0,1) |
| 0,04 " | Triazin (-0,1) |

c)

| | |
|---|---|
| 6,4 Gt<br>0,29 " | Monomeres (- 0,24)<br>Titanocen (+ 0,24) |

d)

| | |
|---|---|
| 3,03 Gt<br>6,48 " | Terpolymeres (+ 0,16)<br>Monomeres (- 0,16) |

e) Änderungen (a) und (d)
f) Änderungen (a), (b), und (d)
g) Änderungen (a), (b), (c) und (d)

Die Mehrfachänderungen (e), (f) und (g) wurden so vorgenommen, daß jeweils die Gesamtmenge konstant blieb. Die Platten wurden im übrigen wie im Beispiel 11 hergestellt und verarbeitet. es wurden die folgenden Anzahlen von vollgedeckten Keilstufen erhalten:

| Beispiel | Keilstufen |
|---|---|
| 15a | 4-5 |
| 15 b | 4 |
| 15 c | 6-7 |
| 15 d | 4 |
| 15 e | 4 |
| 15 f | 4 |
| 15 g | 7-8 |

Beispiele 16-22 (Vergleichsbeispiele)

Druckplatten wurden, wie in Beispiel 1 beschrieben, mit der folgenden Lösung beschichtet:

| | | |
|---|---|---|
| 3,04 | Gt | Bindemittel, |
| 6,06 | " | des in Beispiel 11 angegebenen Monomeren, |
| 0,46 | " | Eosin alkohollöslich, |
| 0,04 | " | des in Beispiel 1 angegebenen Triazins, |
| 0,29 | " | des in Beispiel 1 angegebenen Titanocens und |
| 0,12 | " | Renolblau in |
| 85 | " | Propylenglykolmonomethylether und |
| 46 | " | Butanon |

Die Platten wurden wie in Beispiel 1 beschrieben hergestellt und verarbeitet. die folgende Tabelle zeigt die mit Belichtungszeiten von 20 und 6 Sekunden unter den in Beispiel 1 angegebenen Bedingungen erhaltenen vollgedeckten Keilstufen.

| Beispiel | Bindemittel gemäß Beispiel | Keilstufen | |
|---|---|---|---|
| | | 20 Sekunden | 6 Sekunden |
| 16 | 1 | 7 | 3 |
| 17 | 2 | 7-8 | 3-4 |
| 18 | 3 | - | - |
| 19 | 4 | 8 | 4-5 |
| 20 | 5 | 7-8 | 4 |
| 21 | 6 | 7-8 | 4-5 |
| 22 | 7 | 7 | 4 |

Beispiele 23-31 (davon Vergleichsbeispiele 24, 25, 27, 28, 30 und 31)

Zur Herstellung von Druckplatten wurden Beschichtungslösungen entsprechend der in Beispiel 16 angegebenen Rezeptur eingesetzt, wobei die Art und Menge des Bindemittels sowie die Menge des Monomeren in der folgenden Tabelle angegeben sind. Die Tabelle zeigt ferner die Anzahl der vollgedeckten Keilstufen nach 6 Sekunden Belichtung.

| Beispiel | Bindemittel gemäß Beispiel | Menge Gt | Menge des Monomeren, Gt | Keilstufen |
|---|---|---|---|---|
| 23 | 7 | 1,5 | 7,6 | 5-6 |
| 24 | 7 | 3,0 | 6,1 | 4 |
| 25 | 7 | 4,5 | 4,6 | - |
| 26 | 1 | 1,5 | 7,6 | 5-6 |
| 27 | 1 | 3,0 | 6,1 | 3 |
| 28 | 1 | 4,5 | 4,6 | - |
| 29 | 2 | 1,5 | 7,6 | 5-6 |
| 30 | 2 | 3,0 | 6,1 | 3 |
| 31 | 2 | 4,5 | 4,6 | - |

## Patentansprüche

**1.** Photopolymerisierbares Gemisch, das als wesentliche Bestandteile
a) ein polymeres Bindemittel,
b) eine radikalisch polymerisierbare Verbindung mit mindestens einer polymerisierbaren Gruppe, und als Photoinitiatoren
c) einen photoreduzierbaren Farbstoff,
d) eine durch Strahlung spaltbare Trihalogenmethylverbindung und
e) eine Metallocenverbindung
enthält, dadurch gekennzeichnet, daß das Bindemittel (a) in einer Menge von 5-25 %, die polymerisierbare Verbindung (b) in einer Menge von 60-90 % und die Photoinitiatoren (c), (d) und (e) in einer Menge von insgesamt 3-20 %, bezogen auf das Gewicht der nichtflüchtigen Bestandteile, vorliegen.

**2.** Gemisch nach Anspruch 1, dadurch gekennzeichnet, daß die Metallocenverbindung ein Titanocen oder Zirkonocen ist.

3. Gemisch nach Anspruch 1, dadurch gekennzeichnet, daß das Bindemittel (a) in einer Menge von 10 bis 19 % vorliegt.

4. Gemisch nach Anspruch 1, dadurch gekennzeichnet, daß die Photoinitiatoren (c), (d) und (e) in einer Menge von insgesamt 6 bis 12 % vorliegen.

5. Gemisch nach Anspruch 1, dadurch gekennzeichnet, daß die Metallocenverbindung (e) in einer Menge von 30-55 %, bezogen auf die Gesamtmenge von (c), (d) und (e), vorliegt.

6. Gemisch nach Anspruch 1, dadurch gekennzeichnet, daß die radikalisch polymerisierbare Verbindung ein Acryl- oder Alkacrylsäureester mit mindestens einer bei Belichtung in Gegenwart des photoreduzierbaren Farbstoffs photooxydierbaren Gruppe ist.

7. Gemisch nach Anspruch 6, dadurch gekennzeichnet daß die photooxydierbare Gruppe eine Amino-, Harnstoff-, Thio- oder Enolgruppe ist.

8. Gemisch nach Anspruch 1, dadurch gekennzeichnet, daß der photoreduzierbare Farbstoff ein Xanthen-, Thiazin-, Pyronin-, Porphyrin- oder Acridinfarbstoff ist.

9. Gemisch nach Anspruch 1, dadurch gekennzeichnet, daß die durch Strahlung spaltbare Trihalogenmethylverbindung ein s-Triazin, das durch mindestens eine Trihalogenmethylgruppe und ggf. eine weitere Gruppe substituiert ist, oder ein Aryltrihalogenmethylsulfon ist.

10. Gemisch nach Anspruch 1, dadurch gekennzeichnet, daß es als Photoinitiator ferner eine als Photoinitiator wirksame Acridin-, Phenazin- oder Chinoxalinverbindung enthält.

11. Gemisch nach Anspruch 1, dadurch gekennzeichnet, daß das Bindemittel wasserunlöslich und in wäßrig-alkalischen Lösungen löslich ist.

12. Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

13. Aufzeichnungsmaterial nach Anspruch 12, dadurch gekennzeichnet, daß es auf der photopolymerisierbaren Schicht eine weitere, transparente, für Luftsauerstoff wenig durchlässige Schicht enthält, die in einer Entwicklerflüssigkeit für die photopolymerisierbare Schicht löslich ist.

Europäisches Patentamt

# EUROPÄISCHER RECHERCHENBERICHT

Nummer der Anmeldung

EP 93 10 7786

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,X | EP-A-0 364 735 (HOECHST)<br>* Ansprüche 1-16; Beispiele 1-38 *<br>----- | 1-2,4 | G03F7/029<br>G03F7/027 |
| | | | RECHERCHIERTE SACHGEBIETE (Int. Cl.5) |
| | | | G03F |

Der vorliegende Recherchenbericht wurde für alle Patentansprüche erstellt

| Recherchenort | Abschlußdatum der Recherche | Prüfer |
|---|---|---|
| DEN HAAG | 05 OKTOBER 1993 | FOUQUIER J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)